# EUROPEAN PATENT APPLICATION

(11) **EP 2 688 121 A2**
(43) Date of publication of application: **22.01.2014**
(21) Application number: 13172155.7
(22) Date of filing: 14.06.2013
(51) Int. Cl.: H01L 51/56, C23C 14/56, H01L 21/67

(54) **Organic layer deposition apparatus, method of manufacturing organic light-emitting display apparatus by using the same, and organic light-emitting display apparatus manufactured by the method**

(30) Priority: 16.07.2012 KR 20120077361
(71) Applicant: Samsung Display Co., Ltd., Gyeonggi-Do (KR)
(72) Inventor: Choi, Young-Mook, Gyeonggi-Do (KR)
(74) Representative: Mounteney, Simon James

(57) **Abstract**

An organic layer deposition apparatus includes: a conveyer unit (400) including a transfer unit (430) for attaching a substrate (2), a first conveyer unit (410), and a second conveyer unit (420); and a deposition unit (100) including a vacuum chamber (101) and an organic layer deposition assembly (100-1,...,100-11) for depositing an organic layer on the substrate. The organic layer deposition assembly includes: a deposition source (110) for discharging a deposition material; a deposition source nozzle unit (120) including a plurality of deposition source nozzles; a patterning slit sheet (130) including a plurality of patterning slits that are arranged in a first direction; and a deposition source shutter that moves in the first direction, and selectively blocks the deposition material that is vaporized in the deposition source. The transfer unit moves between the first and second conveyer units. The transfer unit keeps the attached substrate spaced apart from the organic layer deposition assembly while being transferred by the first conveyer unit.

## Description

### BACKGROUND

### 1. Field

The present invention relates to an organic layer deposition apparatus, a method of manufacturing an organic light-emitting display apparatus by using the same, and an organic light-emitting display apparatus manufactured by the method.

### 2. Description of the Related Art

Organic light-emitting display devices have wider viewing angles, better contrast characteristics, and faster response speeds than other display devices, and thus have drawn attention as a next-generation display device.

An organic light-emitting display device includes intermediate layers (including an emission layer) located between a first electrode and a second electrode. The electrodes and the intermediate layers may be formed using various methods, one of which is an independent deposition method. When an organic light-emitting display device is manufactured by using the deposition method, a fine metal mask (FMM) having the same pattern as that of an organic layer to be formed is typically positioned to closely contact a substrate on which the organic layer and the like are formed, and an organic layer material is deposited through the FMM to form the organic layer having a desired pattern.

However, the deposition method using such an FMM presents difficulties in manufacturing larger organic light-emitting display devices using a large mother glass. For example, when such a large mask is used, the mask may bend due to its own weight, thereby distorting a pattern. Such disadvantages might make the FMM method undesirable in view of the recent trend towards high-definition patterns.

Moreover, processes of aligning a substrate and an FMM to closely contact each other, performing deposition thereon, and separating the FMM from the substrate are time-consuming, resulting in a long manufacturing time and low production efficiency.

Information disclosed in this Background section was known to the inventors of the present invention before achieving the present invention or is technical information acquired in the process of achieving the present invention. Therefore, it may contain information that does not form the prior art or information that was already known to a person of ordinary skill in the art prior to the time the present invention was made by the inventors.

### SUMMARY

The present invention sets out to provide an organic layer deposition apparatus that is suitable for use in a mass production of organic light-emitting display apparatuses on a large substrate and enables high-definition patterning. A method of manufacturing an organic light-emitting display apparatus by using the organic layer deposition apparatus, and an organic light-emitting display apparatus manufactured by the method, are also provided.

An organic layer deposition apparatus according to the invention includes: a conveyer unit including a transfer unit for attaching a substrate, the transfer unit being configured to move along with the substrate, a first conveyer unit for moving in a first direction the transfer unit to which the substrate is attached, and a second conveyer unit for moving in a direction opposite to the first direction the transfer unit from which the substrate is separated after deposition has been completed; and a deposition unit including a chamber configured to be maintained in a vacuum state and an organic layer deposition assembly for depositing an organic layer on the substrate attached to the transfer unit. The organic layer deposition assembly includes: a deposition source for discharging a deposition material; a deposition source nozzle unit at a side of the deposition source, and including a plurality of deposition source nozzles; a patterning slit sheet facing the deposition source nozzle unit, and including a plurality of patterning slits that are arranged in a first direction; and a deposition source shutter that is movable in the first direction, and configured to selectively block the deposition material that is vaporized in the deposition source. The transfer unit is configured to move between the first conveyer unit and the second conveyer unit, and to keep the attached substrate spaced apart from the organic layer deposition assembly while being transferred by the first conveyer unit.

The organic layer deposition assembly may further include an angle limiting plate at a side of the deposition source to guide a flow path of the deposition material that is vaporized in the deposition source.

The angle limiting plate may surround a portion of the deposition source.

The deposition source shutter may include a first deposition source shutter and a second deposition source shutter that have a flat plate shape, and the deposition source may be opened or closed due to movement of the first deposition source shutter and the second deposition source shutter.

The deposition source shutter may include a first deposition source shutter and a second deposition source shutter, and each of the first deposition source shutter and the second deposition source shutter may include a flat-plate portion and an inclination portion that is bent from the flat-plate portion.

A groove may be at an end of the inclination portion and may correspond to one of the plurality of deposition source nozzles.

The inclination portion may be configured to guide a flow path of the deposition material that is vaporized in the deposition source.

The deposition source may be opened or closed due to movement of the first deposition source shutter and the second deposition source shutter.

The organic layer deposition apparatus may further include a control sensor at a side of the deposition source to measure a deposition rate of the deposition material that is vaporized in the deposition source.

The control sensor may be configured to measure the deposition rate of the deposition material while the transfer unit moves along with the substrate, and a vaporization amount of the deposition material that is vaporized in the deposition source may be controlled using the deposition rate.

The deposition rate of the deposition source which is measured by the control sensor may be controlled to deposit the deposition material on the substrate by a target thickness.

The first conveyer unit and the second conveyer unit may pass through the deposition unit.

The first conveyer unit and the second conveyer unit may be arranged one over the other in parallel.

The organic layer deposition apparatus may further include: a loading unit for attaching the substrate to the transfer unit; and an unloading unit for separating, from the transfer unit, the substrate on which the deposition has been completed while passing through the deposition unit.

The first conveyer unit may be configured to sequentially transport the transfer unit into the loading unit, the deposition unit, and the unloading unit.

The second conveyer unit may be configured to sequentially transport the transfer unit into the unloading unit, the deposition unit, and the loading unit.

The organic layer deposition assembly may be configured such that the deposition material that is discharged from the deposition source passes through the patterning slit sheet and is then deposited on the substrate while the deposition material forms a pattern on the substrate.

The patterning slit sheet of the organic layer deposition assembly may be smaller than the substrate in at least one of the first direction or a second direction perpendicular to the first direction.

The plurality of deposition source nozzles of the deposition source nozzle unit may be arranged along the first direction, the plurality of patterning slits of the patterning slit sheet may be arranged along the first direction, and the organic layer deposition apparatus may further include a shielding plate assembly including a plurality of shielding plates that are arranged along the first direction between the deposition source nozzle unit and the patterning slit sheet and that partition a space between the deposition source nozzle unit and the patterning slit sheet into a plurality of deposition spaces.

Each of the plurality of shielding plates may extend along a second direction that is substantially perpendicular to the first direction.

The shielding plate assembly may include a first shielding plate assembly including a plurality of first shielding plates, and a second shielding plate assembly including a plurality of second shielding plates.

22. The organic layer deposition apparatus of claim 21, wherein each of the plurality of first shielding plates and each of the plurality of second shielding plates are arranged along a second direction that is substantially perpendicular to the first direction, and partition the space between the deposition source nozzle unit and the patterning slit sheet into the plurality of deposition spaces.

The plurality of deposition source nozzles of the deposition source nozzle unit may be arranged along the first direction, and the plurality of patterning slits of the patterning slit sheet may be arranged along a second direction that is perpendicular to the first direction.

The deposition source and the deposition source nozzle unit, and the patterning slit sheet may be integrally combined by using connection members.

The connection members may be configured to guide a flow path of the deposition material.

The connection members may seal a space among the deposition source, the deposition source nozzle unit, and the patterning slit sheet from an outside.

In another embodiment according to the present invention, a method of manufacturing an organic light-emitting display apparatus is provided. The method includes: moving a transfer unit to which the substrate is attached into a chamber, using a first conveyer unit passing through the chamber; while the substrate and a plurality of organic layer deposition assemblies in the chamber are spaced apart from each other ,and the substrate relatively moves with respect to the organic layer deposition assemblies, depositing deposition materials discharged from the organic layer deposition assemblies on the substrate to form organic layers; and moving the transfer unit, from which the substrate is separated, using a second conveyer unit passing through the chamber. Each of the organic layer deposition assemblies includes: a deposition source for discharging the deposition material; a deposition source nozzle unit at a side of the deposition source, and including a plurality of deposition source nozzles; a patterning slit sheet facing the deposition source nozzle unit, and including a plurality of patterning slits; and a deposition source shutter that is movable in a first direction, and configured to selectively block the deposition material that is vaporized in the deposition source. The depositing the deposition materials includes measuring a deposition rate of each of a plurality of the deposition sources by sequentially opening or closing the plurality of the deposition sources using the deposition source shutter.

Each of the organic layer deposition assemblies may further include an angle limiting plate at a side of the deposition source to guide a flow path of the deposition material that is vaporized in the deposition source.

The deposition source shutter may include a first deposition source shutter and a second deposition source shutter that have a flat plate shape, and the plurality of the deposition sources may be opened or closed due to movement of the first deposition source shutter and the second deposition source shutter.

The deposition source shutter may include a first deposition source shutter and a second deposition source shutter, and each of the first deposition source shutter and the second deposition source shutter may include a flat-plate portion and an inclination portion that is bent from the flat-plate portion.

A groove may be at an end of the inclination portion and correspond to one of the plurality of deposition source nozzles.

The inclination portion may be configured to guide a flow path of the deposition material that is vaporized in the deposition source.

The plurality of the deposition sources may be opened or closed due to movement of the first deposition source shutter and the second deposition source shutter.

The organic layer deposition apparatus may further include a control sensor at a side of the deposition source to measure a deposition rate of the deposition material that is vaporized in the deposition source.

The deposition rate of the deposition material may be measured by the control sensor while the transfer unit moves along with the substrate, and a vaporization amount of the deposition material that is vaporized in the deposition source may be controlled using the deposition rate.

The method may further include, before moving the transfer unit using the first conveyer unit, attaching the substrate to the transfer unit using a loading unit; and before moving the transfer unit using the second conveyer unit, separating the substrate from the transfer unit using an unloading unit after the deposition has been completed on the substrate.

The transfer unit may be configured to move between the first conveyer unit and the second conveyer unit.

The first conveyer unit and the second conveyer unit may be arranged one over the other in parallel.

The patterning slit sheet of the organic layer deposition assembly may be smaller than the substrate in at least one of the first direction or a second direction.

In another exemplary embodiment according to the present invention, an organic light-emitting display device includes: a substrate; a plurality of thin film transistors on the substrate, each of the thin film transistors including a semiconductor active layer, a gate electrode insulated from the semiconductor active layer, and source and drain electrodes each contacting the semiconductor active layer; a plurality of pixel electrodes respectively on the thin film transistors; a plurality of organic layers respectively on the plurality of pixel electrodes; and a counter electrode on the plurality of organic layers. A length of a slanted side between top and bottom sides of at least one of the plurality of organic layers on the substrate farther from a center of a deposition region may be larger than lengths of slanted sides respectively between top and bottom sides of those other organic layers closer to the center of the deposition region, and the at least one of the plurality of organic layers on the substrate is a linearly-patterned organic layer formed using any suitable organic layer deposition apparatus described above.

The plurality of organic layers may include at least an emission layer.

The plurality of organic layers may have a non-uniform thickness.

In each of the organic layers that is farther from the center of the deposition region, the slanted side that is farther from the center of the deposition region may be larger than the other slanted side.

The farther one of the plurality of organic layers in the deposition region is from the center of the deposition region, the narrower an overlapped region of two sides of the one of the plurality of organic layers may be formed.

The slanted sides of the organic layer at the center of the deposition region may have substantially the same length as each other.

The plurality of organic layers in the deposition region may be symmetrically arranged about the center of the deposition region.

The substrate may have a size of 40 inches or more.

At least some of the above features are set out in the claims.

### BRIEF DESCRIPTION OF THE DRAWINGS

The above and other features and aspects of the present invention will become more apparent by describing in detail exemplary embodiments thereof with reference to the attached drawings in which:

FIG. 1 is a schematic plan view illustrating a structure of an organic layer deposition apparatus according to an embodiment of the present invention;

FIG. 2 is a schematic side view of a deposition unit of the organic layer deposition apparatus of FIG. 1 according to an embodiment of the present invention;

FIG. 3 is a schematic perspective view of the deposition unit of the organic layer deposition apparatus of FIG. 1, according to an embodiment of the present invention;

FIG. 4 is a schematic cross-sectional view of the deposition unit of FIG. 3, according to an embodiment of the present invention;

FIG. 5 is a cross-sectional view schematically illustrating a first conveyer unit and a transfer unit of the deposition unit of FIG. 3, according to an embodiment of the present invention;

FIGS. 6A, 6B, and 6C illustrate a deposition source of FIG. 3, an angle limiting plate, and a deposition source shutter, according to an embodiment of the present invention;

FIGS. 7A, 7B, 7C, and 7D illustrate a deposition source of FIG. 3, an angle limiting plate, and a deposition source shutter, according to another embodiment of the present invention;

FIG. 8 is a schematic perspective view of an organic layer deposition assembly according to another embodiment of the present invention;

FIG. 9 is a schematic cross-sectional side view of the organic layer deposition assembly of FIG. 8;

FIG. 10 is a schematic cross-sectional plan view of the organic layer deposition assembly of FIG. 8;

FIG. 11 is a schematic perspective view of an organic layer deposition assembly according to another embodiment of the present invention;

FIG. 12 is a schematic perspective view of an organic layer deposition assembly according to another embodiment of the present invention;

FIG. 13 is a diagram schematically illustrating a structure in which patterning slits are arranged at equal intervals in a patterning slit sheet of the organic layer deposition apparatus, according to an embodiment of the present invention;

FIG. 14 is a diagram schematically illustrating organic layers formed on the substrate by using the patterning slit sheet of FIG. 13, according to an embodiment of the present invention; and

FIG. 15 is a schematic cross-sectional view of an active matrix-type organic light-emitting display device manufactured by using the organic layer deposition apparatus, according to an embodiment of the present invention.

### DETAILED DESCRIPTION

Hereinafter, embodiments of the present invention will be described in detail by explaining embodiments of the invention with reference to the attached drawings. Like reference numerals in the drawings denote like elements.

Reference will now be made in detail to the embodiments of the present invention, examples of which are illustrated in the accompanying drawings, wherein like reference numerals refer to the like elements throughout. The embodiments are described below in order to explain aspects of the present invention by referring to the figures. Expressions such as "at least one of," when preceding a list of elements, modify the entire list of elements and do not modify the individual elements of the list.

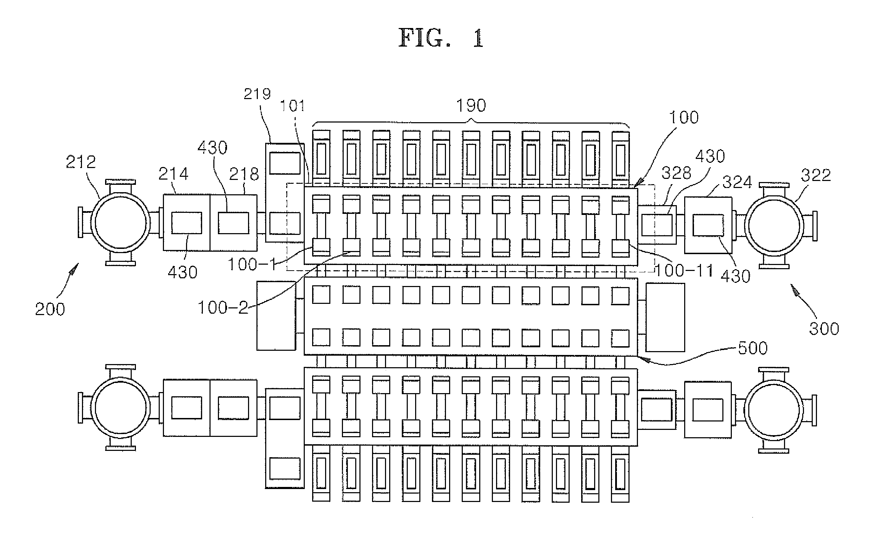

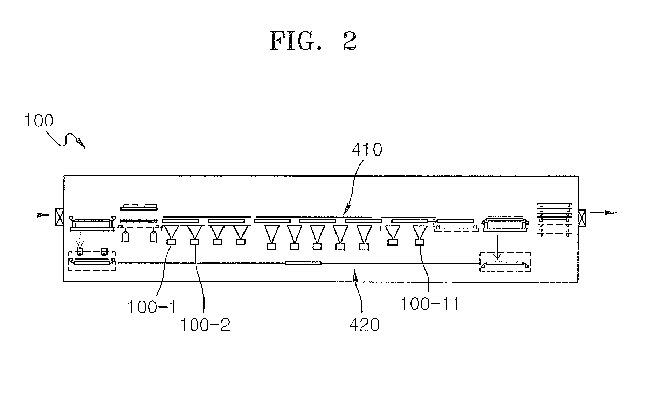

FIG. 1 is a schematic plan view illustrating a structure of an organic layer deposition apparatus 1 according to an embodiment of the present invention. FIG. 2 is a schematic side view of a deposition unit 100 of the organic layer deposition apparatus 1 of FIG. 1, according to an embodiment of the present invention.

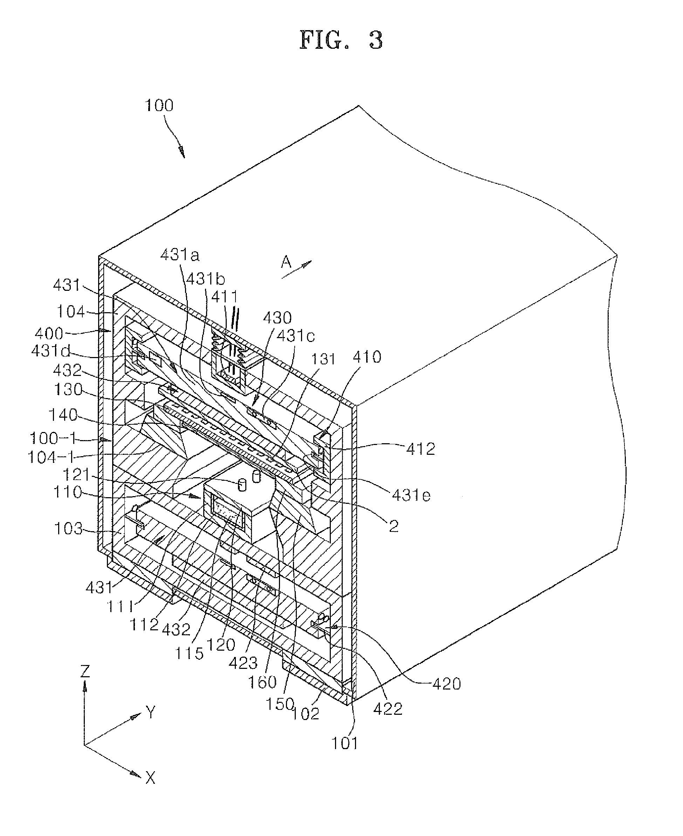

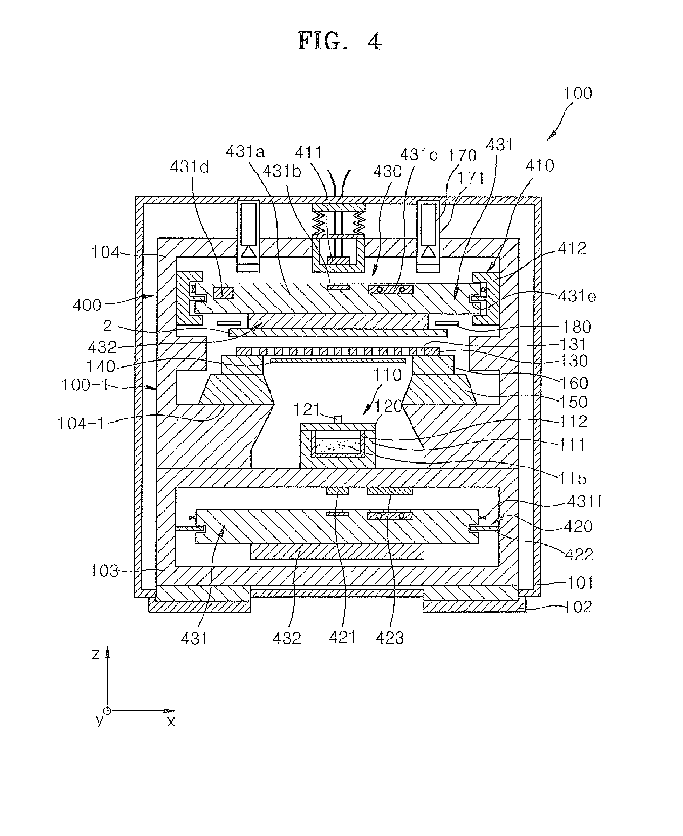

Referring to FIGS. 1 and 2, the organic layer deposition apparatus 1 includes the deposition unit 100, a loading unit 200, an unloading unit 300, and a conveyer unit 400 (also see for example, FIGS. 3 and 4).

The loading unit 200 includes a first rack 212, a transport chamber 214, a first inversion chamber 218, and a buffer chamber 219.

A plurality of substrates 2 (for example, one substrate 2 is shown in FIGS. 3 and 4) onto which a deposition material has not yet been applied are stacked up on the first rack 212. A transport robot included in the transport chamber 214 picks up one of the substrates 2 from the first rack 212, places it on a transfer unit 430 transferred by a second conveyer unit 420, and moves the transfer unit 430 on which the substrate 2 is placed into the first inversion chamber 218.

The first inversion chamber 218 is located adjacent to the transport chamber 214. The first inversion chamber 218 includes a first inversion robot that inverts the transfer unit 430 and then loads it on a first conveyer unit 410 of the deposition unit 100.

Referring to FIG. 1, the transport robot of the transport chamber 214 places one of the substrates 2 on a top surface of the transfer unit 430, and the transfer unit 430 on which the substrate 2 is placed is then transferred into the first inversion chamber 218. The first inversion robot of the first inversion chamber 218 inverts the transfer unit 430 so that the substrate 2 is turned upside down in the deposition unit 100.

The unloading unit 300 is configured to operate in an opposite manner to the loading unit 200 described above. Specifically, a second inversion robot in a second inversion chamber 328 inverts the transfer unit 430, which has passed through the deposition unit 100 while the substrate 2 is placed on the transfer unit 430, and then moves the transfer unit 430 on which the substrate 2 is placed into an ejection chamber 324. Then, an ejection robot takes the transfer unit 430 on which the substrate 2 is placed out of the ejection chamber 324, separates the substrate 2 from the transfer unit 430, and then loads the substrate 2 on a second rack 322. The transfer unit 430, separated from the substrate 2, is returned to the loading unit 200 via the second conveyer unit 420.

However, the present invention is not limited to the above example. For example, when placing the substrate 2 on the transfer unit 430, the substrate 2 may be fixed (or attached) onto a bottom surface of the transfer unit 430 and then moved into the deposition unit 100. In such an embodiment, for example, the first inversion robot of the first inversion chamber 218 and the second inversion robot of the second inversion chamber 328 may be omitted.

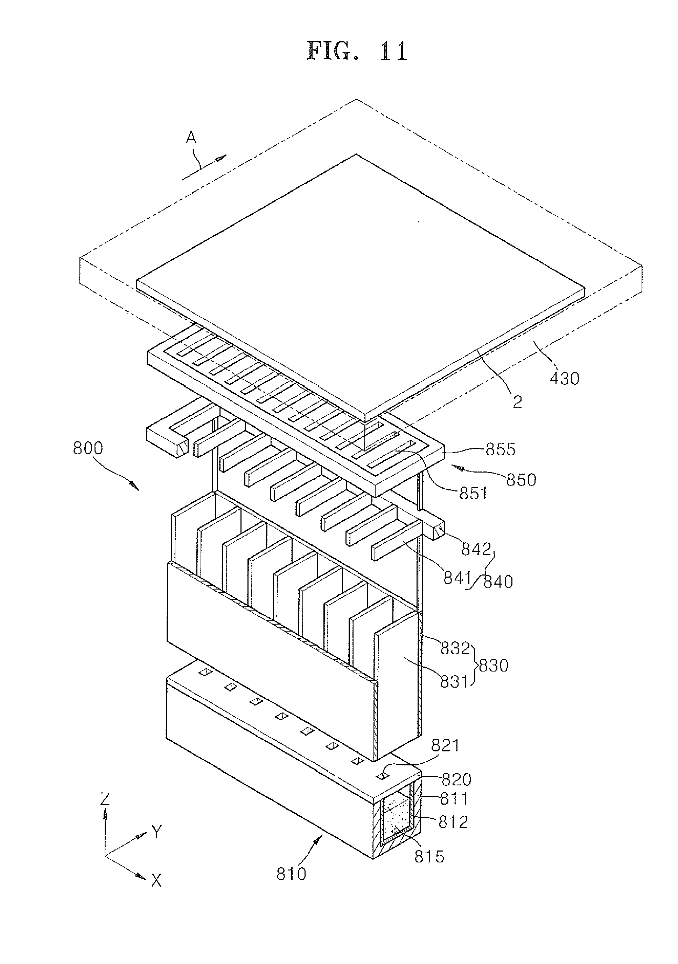

The deposition unit 100 includes at least one chamber for deposition. In one embodiment, as illustrated in FIGS. 1 and 2, the deposition unit 100 includes a chamber 101 in which a plurality of organic layer deposition assemblies 100-1, 100-2,..., 100-n may be located. Referring to FIG. 1, 11 organic layer deposition assemblies, i.e., a first organic layer deposition assembly 100-1, a second organic layer deposition assembly 100-2 through an eleventh organic layer deposition assembly 100-11, are located in the chamber 101, but the number of organic layer deposition assemblies may vary with a desired deposition material and deposition conditions. The chamber 101 is maintained in vacuum during the deposition process.

In the embodiment illustrated in FIG. 1, the transfer unit 430 with the substrate 2 fixed thereon (or attached thereto) may be moved at least to the deposition unit 100 or may be moved sequentially to the loading unit 200, the deposition unit 100, and the unloading unit 300, by the first conveyer unit 410, and the transfer unit 430 that is separated from the substrate 2 in the unloading unit 300 may be moved back to the loading unit 200 by the second conveyer unit 420.

The first conveyer unit 410 passes through the chamber 101 when passing through the deposition unit 100, and the second conveyer unit 420 conveys (or transports) the transfer unit 430 from which the substrate 2 is separated.

In the present embodiment, the organic layer deposition apparatus 1 is configured such that the first conveyer unit 410 and the second conveyer unit 420 are respectively disposed above and below so that after the transfer unit 430, on which deposition has been completed while passing through the first conveyer unit 410, is separated from the substrate 2 in the unloading unit 300, the transfer unit 430 is returned to the loading unit 200 via the second conveyer unit 420 formed below the first conveyer unit 410, whereby the organic layer deposition apparatus 1 may have an improved space utilization efficiency.

In an embodiment, the deposition unit 100 of FIG. 1 may further include a deposition source replacement unit 190 located at a side of each organic layer deposition assembly. Although not particularly illustrated in the drawings, the deposition source replacement unit 190 may be formed as a cassette-type that may be drawn to the outside from each organic layer deposition assembly. Thus, a deposition source 110 (refer to FIG. 3) of the organic layer deposition assembly 100-1 may be easily replaced.

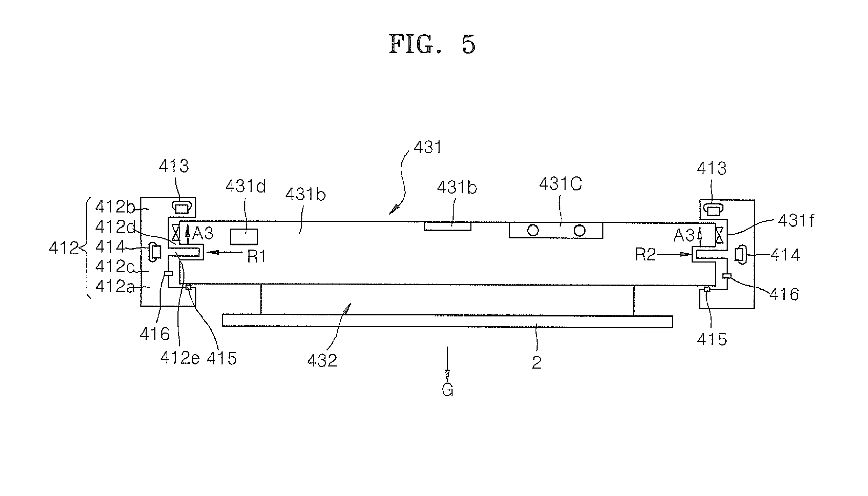

FIG. 3 is a schematic perspective view of the deposition unit 100 of the organic layer deposition apparatus 1 of FIG. 1, according to an embodiment of the present invention. FIG. 4 is a schematic cross-sectional view of the deposition unit 100 of FIG. 3, according to an embodiment of the present invention. FIG. 5 is a cross-sectional view schematically illustrating a first conveyer unit 410 and a transfer unit 430 of the deposition unit 100 of FIG. 3, according to an embodiment of the present invention.

Referring to FIGS. 3 and 4, the deposition unit 100 of the organic layer deposition apparatus 1 includes at least one organic layer deposition assembly 100-1 and a conveyer unit 400.

Hereinafter, an overall structure of the deposition unit 100 will be described.

The chamber 101 is formed as a hollow box type and accommodate the at least one organic layer deposition assembly 100-1 and the transfer unit 430. In another descriptive manner, a foot 102 is formed so as to fix the deposition unit 100 on the ground, a lower housing 103 is located on the foot 102, and an upper housing 104 is located on the lower housing 103. The chamber 101 accommodates both the lower housing 103 and the upper housing 104. In this regard, a connection part of the lower housing 103 and the chamber 101 is sealed so that the inside of the chamber 101 is completely isolated from the outside. Due to the structure in which the lower housing 103 and the upper housing 104 are located on the foot 102 fixed on the ground, the lower housing 103 and the upper housing 104 may be maintained in a fixed position even though the chamber 101 is repeatedly contracted and expanded. Thus, the lower housing 103 and the upper housing 104 may serve as a reference frame in the deposition unit 100.

The upper housing 104 includes the organic layer deposition assembly 100-1 and the first conveyer unit 410 of the conveyer unit 400, and the lower housing 103 includes the second conveyer unit 420 of the conveyer unit 400. While the transfer unit 430 is cyclically moving between the first conveyer unit 410 and the second conveyer unit 420, a deposition process is continuously performed.

Hereinafter, constituents of the organic layer deposition assembly 100-1 are described in detail.

The first organic layer deposition assembly 100-1 includes the deposition source 110, a deposition source nozzle unit 120, a patterning slit sheet 130, a shielding member 140, a first stage 150, a second stage 160, a camera (or cameras) 170, and a sensor (or sensors) 180. In this regard, all the elements illustrated in FIGS. 3 and 4 may be arranged in the chamber 101 maintained in an appropriate vacuum state. This structure is used to achieve the linearity of a deposition material.

For example, in order to deposit a deposition material 115 that has been discharged from the deposition source 110 and passed through the deposition source nozzle unit 120 and the patterning slit sheet 130, onto the substrate 2 in a desired pattern, it is desirable to maintain the chamber in the same vacuum state as that used in a deposition method using a fine metal mask (FMM). In addition, the temperature of the patterning slit sheet 130 should be sufficiently lower than that of the deposition source 110 (e.g., about 100°C or less) because thermal expansion of the patterning slit sheet 130 is reduced or minimized when the temperature of the patterning slit sheet 130 is sufficiently low.

The substrate 2 on which the deposition material 115 is to be deposited is arranged in the chamber 101. The substrate 2 may be a substrate for a flat panel display device. For example, a large substrate (e.g., having a size of 40 inches or more), such as a mother glass, for manufacturing a plurality of flat panel displays, may be used as the substrate 2.

According to the present embodiment, the deposition process may be performed with the substrate 2 being moved relative to the organic layer deposition assembly 100-1.

In a conventional deposition method using an FMM, the size of the FMM is the same as that of a substrate. Thus, as the size of the substrate increases, the size of the FMM also increases. Due to these problems, it is difficult to fabricate the FMM and to align the FMM in a precise pattern by elongation of the FMM.

To address these problems, in the organic layer deposition assembly 100-1 according to the present embodiment, deposition may be performed while the organic layer deposition assembly 100-1 and the substrate 2 are moved relative to each other. In other words, deposition may be continuously performed while the substrate 2, which faces the organic layer deposition assembly 100-1, is moved in a Y-axis direction. That is, deposition is performed in a scanning manner while the substrate 2 is moved in a direction of arrow A illustrated in FIG. 3. Although the substrate 2 is illustrated as being moved in the Y-axis direction in the chamber 101 in FIG. 3 when deposition is performed, the present invention is not limited thereto. For example, deposition may be performed while the organic layer deposition assembly 100-1 is moved in the Y-axis direction and the substrate 2 is held in a fixed position.

Thus, in the organic layer deposition assembly 100-1, the patterning slit sheet 130 may be smaller (e.g., much smaller) than an FMM used in a conventional deposition method. In other words, in the organic layer deposition assembly 100-1, deposition is continuously performed, i.e., in a scanning manner while the substrate 2 is moved in the Y-axis direction. Thus, at least one of the lengths of the patterning slit sheet 130 in X-axis and Y-axis directions may be less (e.g., much less) than a length of the substrate 2. Because the patterning slit sheet 130 may be formed smaller (e.g., much smaller) than the FMM used in a conventional deposition method, it is relatively easy to manufacture the patterning slit sheet 130. That is, the small patterning slit sheet 130 is more suitable in view of the manufacturing processes, including etching followed by precise elongation, welding, transferring, and washing processes, than the FMM used in a conventional deposition method. In addition, this is more suitable for manufacturing a relatively large display device.

In order to perform deposition while the organic layer deposition assembly 100-1 and the substrate 2 are moved relative to each other as described above, the organic layer deposition assembly 100-1 and the substrate 2 may be spaced apart from each other by a certain distance (e.g., a gap). This is described below in more detail.

The deposition source 110 that contains and heats the deposition material 115 is located at a side opposite to (facing) a side in which the substrate 2 is located in the chamber. As the deposition material 115 contained in the deposition source 110 is vaporized, deposition is performed on the substrate 2.

The deposition source 110 includes a crucible 111 that is filled with the deposition material 115 and a heater 112 that heats the crucible 111 so as to vaporize the deposition material 115 toward a side of the crucible 111 filled with the deposition material 115, in particular, toward the deposition source nozzle unit 120.

The deposition source 110, in one embodiment, is located at a side of the deposition source 110 facing the substrate 2. In this regard, the organic layer deposition assemblies according to the present embodiment each may include different deposition nozzles in performing deposition for forming common layers and pattern layers. That is, a plurality of deposition source nozzles 121 may be arranged along the Y-axis direction, i.e., a scanning direction of the substrate 2, at the deposition source nozzle unit 120 so as to form a pattern layer. Accordingly, only one deposition source nozzle 121 is formed or arranged along the X-axis direction, so that the occurrence of shadows may be reduced (e.g., significantly reduced). On the other hand, the plurality of deposition source nozzles 121 may be arranged along the X-axis direction at the deposition source nozzle unit 120 so as to form a common layer. By doing so, a thickness uniformity of the common layer may be improved.

In one embodiment, the patterning slit sheet 130 may be located between the deposition source 110 and the substrate 2. The patterning slit sheet 130 may further include a frame having a shape similar to a window frame. The patterning slit sheet 130 includes a plurality of patterning slits 131 arranged along the X-axis direction. The deposition material 115 that has been vaporized in the deposition source 110 passes through the deposition source nozzle unit 120 and the patterning slit sheet 130 and is then deposited onto the substrate 2. In this regard, the patterning slit sheet 130 may be formed using the same method as that used to form an FMM, in particular, a stripe-type mask, e.g., etching. In this regard, a total number of patterning slits 131 may be more than a total number of deposition source nozzles 121.

In one embodiment, the deposition source 110 (and the deposition source nozzle unit 120 combined thereto) and the patterning slit sheet 130 may be spaced apart from each other by a certain distance (e.g., a gap).

As described above, deposition is performed while the organic layer deposition assembly 100-1 is moved relative to the substrate 2. In order for the organic layer deposition assembly 100-1 to be moved relative to the substrate 2, the patterning slit sheet 130 is spaced apart from the substrate 2 by a certain distance (e.g., a gap).

In a conventional deposition method using an FMM, deposition is typically performed with the FMM in close contact with a substrate in order to prevent formation of shadows on the substrate. However, when the FMM is formed in close contact with the substrate, defects due to the contact between the substrate and the FMM may occur. In addition, because it is difficult to move the mask with respect to the substrate, the mask and the substrate have the same size. Accordingly, the mask becomes larger as the size of a display device increases. However, it is difficult to form a large mask.

To address these problems, in the organic layer deposition assembly 100-1 according to the present embodiment, the patterning slit sheet 130 is formed spaced apart by a certain distance (e.g., a gap) from the substrate 2 on which a deposition material is to be deposited.

According to the present embodiment, deposition may be performed while a mask formed smaller than a substrate is moved with respect to the substrate, and thus, it is relatively easy to manufacture the mask. In addition, defects due to contact between the substrate and the mask may be prevented. In addition, because it is unnecessary to closely contact the substrate with the mask during a deposition process, a manufacturing speed may be improved.

Hereinafter, particular disposition of each element of the upper housing 104 will be described.

The deposition source 110 and the deposition source nozzle unit 120 are located at a bottom portion of the upper housing 104. Accommodation portions 104-1 are respectively formed on both sides of the deposition source 100 and the deposition source nozzle unit 120 to have a protruding shape. The first stage 150, the second stage 160, and the patterning slit sheet 130 are sequentially formed (or located) on the accommodation portions 104-1 in this order.

In this regard, the first stage 150 is formed to move in X-axis and Y-axis directions so that the first stage 150 aligns the patterning slit sheet 130 in the X-axis and Y-axis directions. That is, the first stage 150 includes a plurality of actuators so that the first stage 150 is moved in the X-axis and Y-axis directions with respect to the upper housing 104.

The second stage 160 is formed to move in a Z-axis direction so as to align the patterning slit sheet 130 in the Z-axis direction. That is, the second stage 160 includes a plurality of actuators and is formed to move in the Z-axis direction with respect to the first stage 150.

The patterning slit sheet 130 is located on the second stage 160. The patterning slit sheet 130 is located on the first stage 150 and the second stage 160 so as to move in the X-axis, Y-axis, and Z-axis directions, and thus, an alignment, in particular, a real-time alignment, between the substrate 2 and the patterning slit sheet 130, may be performed.

In addition, the upper housing 104, the first stage 150, and the second stage 160 may guide a flow path of the deposition material 115 such that the deposition material 115 discharged through the deposition source nozzles 121 is not dispersed outside the flow path. That is, the flow path of the deposition material 115 is sealed by the upper housing 104, the first stage 150, and the second stage 160, and thus, the movement of the deposition material 115 in the X-axis and Y-axis directions may be thereby concurrently or simultaneously guided.

The shielding member 140 may be located between the patterning slit sheet 130 and the deposition source 110 so as to prevent an organic material from being deposited on a non-film-forming region of the substrate 2. Although not illustrated, the shielding member 140 may include two adjacent plates. Since the non-film-forming region of the substrate 2 is screened by the shielding member 140, it may be easy to prevent the organic material from being deposited on the non-film-forming region of the substrate 2 without using a separate structure.

Hereinafter, the conveyer unit 400 that conveys (e.g., transports) the substrate 2, on which the deposition material 115 is to be deposited, is described in more detail. Referring to FIGS. 3 and 4, the conveyer unit 400 includes the first conveyer unit 410, the second conveyer unit 420, and the transfer unit 430.

The first conveyer unit 410 conveys (or transports) in an in-line manner the transfer unit 430, including the carrier 431 and an electrostatic chuck 432 attached thereto, and the substrate 2 attached to the transfer unit 430 so that an organic layer may be formed on the substrate 2 by the organic layer deposition assembly 100-1. The first conveyer unit 410 includes a coil 411, guide members 412, upper magnetically suspended bearings (e.g., magnetically levitating or magnetic levitation bearings) 413, side magnetically suspended bearings (e.g., magnetically levitating or magnetic levitation bearings) 414, and gap sensors 415 and 416 (for example, also see FIG. 5).

The second conveyer unit 420 returns to the loading unit 200 the transfer unit 430 from which the substrate 2 has been separated in the unloading unit 300 after one deposition cycle is completed while the transfer unit 430 is passing through the deposition unit 100. The second conveyer unit 420 includes a coil 421, roller guides 422, and a charging track 423.

The transfer unit 430 includes the carrier 431 that is conveyed (or transported) along the first conveyer unit 410 and the second conveyer unit 420 and the electrostatic chuck 432 that is combined on (or attached to) a surface of the carrier 431. The substrate 2 is attached to the electrostatic chuck 432.

Hereinafter, each element of the conveyer unit 400 will be described in more detail.

The carrier 431 of the transfer unit 430 will now be described in detail.

The carrier 431 includes a main body part 431a, a magnetic rail (or a linear motor system (LMS) magnet) 431b, contactless power supply (CPS) modules 431c, a power supply unit 431d, and guide grooves 431e. The carrier 431 further includes cam followers 431f.

The main body part 431a constitutes a base part of the carrier 431 and may be formed of a magnetic material such as iron. In this regard, due to a magnetic repulsive force (and/or a magnetic attractive force) between the main body part 431a and the respective upper and side magnetically suspended bearings (e.g., magnetic levitation bearings) 413 and 414, which are described below, the carrier 431 may be maintained spaced apart from the guide members 412 by a certain distance (e.g., a gap).

The guide grooves 431e are respectively formed at both sides of the main body part 431a and each may accommodate a guide protrusion 412e of the guide member 412.

The magnetic rail 431b is formed along a center line of the main body part 431a in a direction where the main body part 431a proceeds. The magnetic rail 431b and the coil 411, which are described below in more detail, may be combined with each other to constitute a linear motor, and the carrier 431 may be conveyed (or transported) in an arrow A direction by the linear motor.

The CPS modules 431c and the power supply unit 431 d are respectively formed on both sides of the magnetic rail 431b in the main body part 431a. The power supply unit 431d includes a battery (e.g., a rechargeable battery) that provides power so that the electrostatic chuck 432 can chuck (e.g., fix or hold) the substrate 2 and maintains operation. The CPS modules 431c are wireless charging modules that charge the power supply unit 431d. For example, the charging track 423 formed in the second conveyer unit 420, which is described below, is connected to an inverter (not shown), and thus, when the carrier 431 is transferred into the second conveyer unit 420, a magnetic field is formed between the charging track 423 and the CPS modules 431c so as to supply power to the CPS module 431c. The power supplied to the CPS modules 431c is used to charge the power supply unit 431d.

The electrostatic chuck 432 may include an electrode embedded in a main body formed of ceramic, wherein the electrode is supplied with power. The substrate 2 is attached onto a surface of the main body of the electrostatic chuck 432 as a suitable voltage (e.g., a high voltage or a relatively high voltage) is applied to the electrode.

Hereinafter, an operation of the transfer unit 430 is described in more detail.

The magnetic rail 431b of the main body part 431a and the coil 411 are combined with each other to constitute an operation unit. In this embodiment, the operation unit is a linear motor. The linear motor has a small frictional coefficient, little position error, and a high degree (e.g., a very high degree) of position determination, as compared to a conventional slide guide system. As described above, the linear motor includes the coil 411 and the magnetic rail 431b. The magnetic rail 431b is linearly located (or arranged) on the carrier 431, and a plurality of the coils 411 are located at an inner side of the chamber 101 by a certain distance so as to face the magnetic rail 431b. Because the magnetic rail 431b is located at the carrier 431 instead of the coil 411, the carrier 431 may be operable without power being supplied thereto. In this regard, the coil 411 may be formed in an atmosphere (ATM) box in an air atmosphere, and the carrier 431 to which the magnetic rail 431b is attached may be moved in the chamber 101 maintained in vacuum.

Hereinafter, the first conveyer unit 410 and the transfer unit 430 are described in detail.

Referring to FIGS. 4 and 5, the first conveyer unit 410 conveys (or transports) the electrostatic chuck 432 that fixes (or attaches to) the substrate 2 and the carrier 431 that conveys (or transports) the electrostatic chuck 432. In this regard, the first conveyer unit 410 includes the coil 411, the guide members 412, the upper magnetically suspended (e.g., magnetic levitation) bearings 413, the side magnetically suspended (e.g., magnetic levitation) bearings 414, and the gap sensors 415 and 416.

The coil 411 and the guide members 412 are formed (or located) inside the upper housing 104. The coil 411 is formed (or located) in an upper portion of the upper housing 104, and the guide members 421 are respectively formed on both inner sides of the upper housing 104.

The guide members 412 guide the carrier 431 to move in a direction. In this regard, the guide members 412 are formed to pass through the deposition unit 100.

For example, the guide members 412 accommodate both sides of the carrier 431 to guide the carrier 431 to move along in the direction of arrow A illustrated in FIG. 3. In this regard, each of the guide members 412 includes a first accommodation part 412a located below the carrier 431, a second accommodation part 412b located above the carrier 431, and a connection part 412c that connects the first accommodation part 412a and the second accommodation part 412b to each other. An accommodation groove 412d is formed by the first accommodation part 412a, the second accommodation part 412b, and the connection part 412c. Both sides of the carrier 431 are respectively accommodated in the accommodation grooves 412d, and the carrier 431 is moved along the accommodation grooves 412d.

The side magnetically suspended (e.g., magnetic levitation) bearings 414 are each located at the connection part 412c of the guide member 412 so as to respectively correspond to both sides of the carrier 431. The side magnetically suspended (e.g., magnetic levitation) bearings 414 cause a distance (e.g., a gap) between the carrier 431 and the guide member 412 so that the carrier 431 is moved along the guide members 412 in non-contact with (i.e., without contacting) the guide members 412. That is, a repulsive force R1 occurring between the side magnetically suspended (e.g., magnetic levitation) bearing 414 on the left side in FIG. 5 and the carrier 431, which is a magnetic material, and a repulsive force R2 occurring between the side magnetically suspended (e.g., magnetic levitation) bearing 414 on the right side in FIG. 5 and the carrier 431, which is a magnetic material, maintain equilibrium, and thus, there is a constant (or substantially constant) distance between the carrier 431 and the respective parts of the guide member 412.

Each upper magnetically suspended (e.g., magnetic levitation) bearing 413 is located at the second accommodation part 412b so as to be above the carrier 431. The upper magnetically suspended bearings 413 enable the carrier 431 to be moved along the guide members 412 in non-contact with (i.e., without contacting) the first and second accommodation parts 412a and 412b and with a distance (e.g., a gap) therebetween maintained constant (or substantially constant). That is, an attractive force A3 occurring between the upper magnetically suspended (e.g., magnetic levitation) bearing 413 and the carrier 431, which is made of a magnetic material, and gravity G maintain equilibrium, and thus, there is a constant (or substantially constant) distance between the carrier 431 and the respective guide members 412.

Each guide member 412 further includes the gap sensor 415. The gap sensor 415 may measure a distance between the carrier 431 and the guide member 412. Referring to FIG. 5, the gap sensor 415 is located at the first accommodation part 412a so as to correspond to a bottom portion of the carrier 431. The gap sensor 415 located at the first accommodation part 412a may measure a distance between the first accommodation part 412a and the carrier 431. The gap sensor 416 is located at a side of the side magnetically suspended bearing (e.g., magnetic levitation bearing) 414. The gap sensor 416 may measure a distance between a side surface of the carrier 431 and the side magnetically suspended bearing 414. The present invention is not limited to the above example, and the gap sensor 416 may be located at the connection part 412c.

Magnetic forces of the upper and side magnetically suspended bearings (e.g., magnetic levitation bearings) 413 and 414 may vary according to values measured by the gap sensors 415 and 416, and thus, distances between the carrier 431 and the respective guide members 412 may be adjusted in real time. That is, a precise transfer of the carrier 431 may be feedback controlled using the upper and side magnetically suspended bearings (e.g., magnetic levitation bearings) 413 and 414 and the gap sensors 415 and 416.

Hereinafter, the second conveyer unit 420 and the transfer unit 430 are described in detail.

Referring back to FIG. 4, the second conveyer unit 420 returns the electrostatic chuck 432 from which the substrate 2 has been separated in the unloading unit 300 and the carrier 431 that carries the electrostatic chuck 432, to the loading unit 200. In this regard, the second conveyer unit 420 includes the coil 421, the roller guides 422, and the charging track 423.

In particular, the coil 421, the roller guides 422, and the charging track 423 are positioned inside the lower housing 103. The coil 421 and the charging track 423 are located at a top inner surface of the lower housing 103, and the roller guides 422 are located at both inner sides of the lower housing 103. Although not specifically illustrated in FIG. 4, the coil 421 is located in an ATM box, similar to the coil 411 of the first conveyer unit 410.

Similar to the first conveyer unit 410, the second conveyer unit 420 includes the coil 421. Also, the magnetic rail (e.g., the LMS magnet) 431b of the main body part 431a of the carrier 431 and the coil 421 are combined with each other to constitute an operation unit. In this regard, the operation unit may be a linear motor. The carrier 431 may be moved by the linear motor along a direction opposite to the direction of arrow A illustrated in FIG. 3.

The roller guides 422 guide the carrier 431 to move in a direction. In this regard, the roller guides 422 are formed to pass through the deposition unit 100. In particular, the roller guides 422 support cam followers 431f (for example, see FIG. 5) respectively formed on both sides of the carrier 431 to guide the carrier 431 to move along a direction opposite to the direction of arrow A illustrated in FIG. 3. That is, the carrier 431 is moved with the cam followers 431f located at both sides of the carrier 431 respectively rotating along the roller guides 422. In this regard, the cam followers 431f are utilized as bearings used to accurately repeat a particular operation. In an embodiment, a plurality of the cam followers 431f are formed on (or located at) a side surface of the carrier 431 and serve as a wheel for conveying (or transporting) the carrier 431 in the second conveyer unit 420. A detailed description of the cam followers 431f is not provided herein.

The second conveyer unit 420 is used in a process of returning the carrier 431 from which the substrate 2 has been separated and not in a process of depositing an organic material on the substrate 2, and thus, position accuracy (e.g., positional accuracy) thereof is not needed as by the first conveyer unit 410. Therefore, magnetic suspension is applied to the first conveyer unit 410 that requires high position accuracy, thereby obtaining position accuracy, and a conventional roller method is applied to the second conveyer unit 420 that requires relatively low position accuracy, thereby reducing manufacturing costs and simplifying a structure of the organic layer deposition apparatus. Although not illustrated in FIG. 4, the magnetic suspension (or magnetic levitation) may also be applied to the second conveyer unit 420 as in the first conveyer unit 410.

The organic layer deposition assembly 100-1 of the organic layer deposition apparatus 1 according to the present embodiment further includes the cameras 170 and the sensors 180 for an aligning process. In more detail, the cameras 170 may align in real time a first alignment mark (not shown) formed in the frame 135 of the patterning slit sheet 130 and a second alignment mark (not shown) formed on the substrate 2. The sensors 180 may be confocal sensors. Because a distance between the substrate 2 and the patterning slit sheet 130 is measurable in real time using the cameras 170 and the sensors 180, the substrate 2 may be aligned with the patterning slit sheet 130 in real time, whereby position accuracy of a pattern may be improved (e.g., significantly improved).

Hereinafter, the deposition source 110, an angle limiting plate 145, and a deposition source shutter of the organic layer deposition apparatus 1 are described in detail.

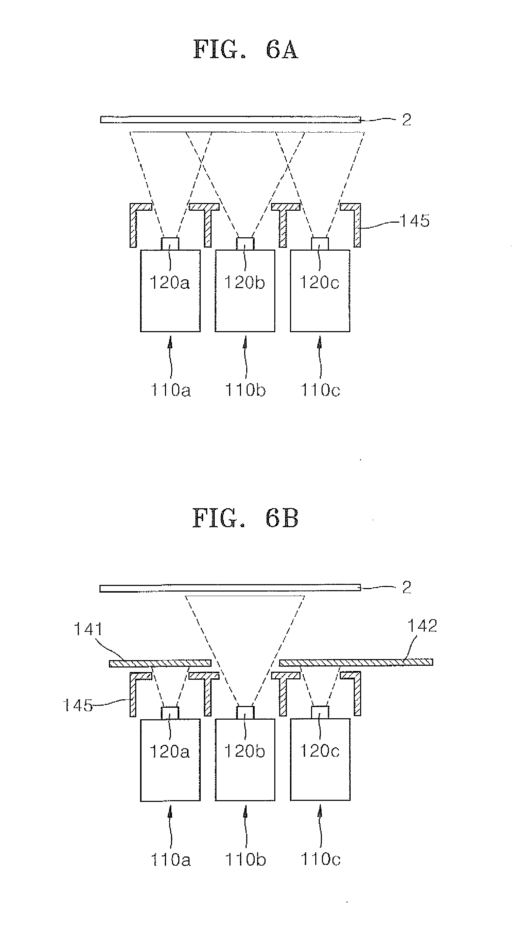

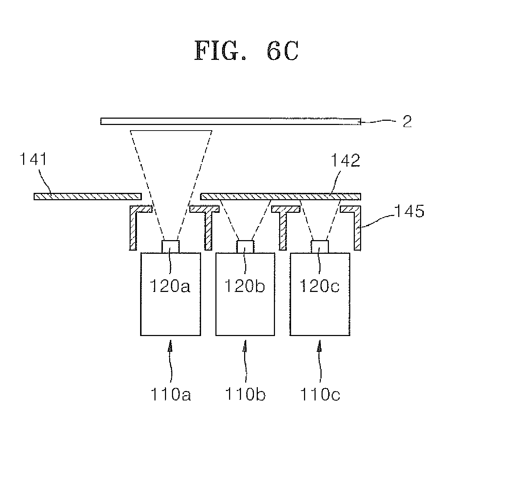

FIGS. 6A, 6B, and 6C illustrate the deposition source 110 of FIG. 3, the angle limiting plate 145, and a deposition source shutter, according to an embodiment of the present invention.

Referring to FIGS. 6A, 6B, and 6C, the angle limiting plate 145 surrounds a portion of the deposition source 110 so as to guide a flow path of a deposition material that is vaporized in the deposition source 110. The angle limiting plate 145 having a '¬' (e.g., letter 'L' rotated by 180 degrees) shape is formed at both sides of the deposition source 110, so that the angle limiting plate 145 limits a discharge path of the deposition material that is vaporized in the deposition source 110, and increases linearity of the deposition material. That is, the deposition material that is vaporized in the deposition source 110 and that moves with an angle close to 90 degrees moves toward the substrate 2 without bumping into the angle limiting plate 145, whereas a deposition material that is vaporized in the deposition source 110 and that diagonally moves with an angle less than or equal to a predetermined angle bumps into the angle limiting plate 145 and thus is deposited on the angle limiting plate 145. By arranging the angle limiting plate 145, the linearity of the deposition material may be improved or achieved, so that the occurrence of shadows may be reduced (e.g., significantly reduced).

The deposition source shutter is further arranged at a side of the angle limiting plate 145, i.e., between the angle limiting plate 145 and the patterning slit sheet 130 (referring to FIG. 4). The deposition source shutter includes a first deposition source shutter 141 and a second deposition source shutter 142 that have a flat plate shape and that are movable in the same direction (i.e., the direction of arrow A illustrated in FIG. 3) as a movement direction of the substrate 2. The first and second deposition source shutters 141 and 142 may block a deposition material from another deposition source in a tooling operation. This is described in detail.

For example, a characteristic of an organic light-emitting device considerably (or substantively) depends on a thickness of an organic layer. Thus, in order to manufacture an organic light-emitting display apparatus having a high quality, it is essential to perform the tooling operation so as to adjust thicknesses of all organic layers before a film-forming operation is performed. Here, the tooling operation refers to a process in which deposition with respect to a target organic layer is performed by a predetermined deposition rate on a substrate whereon a device (e.g., a TFT) is not deposited, a thickness of the substrate whereon the organic layer is deposited is measured by using an analysis equipment such as an ellipsometer capable of measuring a thickness, and then a tooling factor (TF) of the organic layer is changed or the deposition rate is adjusted by using the measured thickness. In this regard, the TF indicates a control parameter in the tooling operation based on a ratio of the thickness of the organic layer, which is actually measured by using a sensor, to a target thickness of the organic layer.

When the tooling operation is performed on the organic layer formed on the substrate, the tooling operation is separately performed according to each of types of target organic layers, each of deposition sources, and/or each of deposition assemblies. For example, the organic layer deposition apparatus 1 of FIG. 1 has the organic layer deposition assemblies 100-1 through 100-11, and each of the organic layer deposition assemblies 100-1 through 100-11 has three deposition sources, so that a total of 33 tooling operations typically proceed so as to perform the tooling operation on all deposition sources. Here, in order to perform the tooling operation on each of three deposition sources in one organic layer deposition assembly, when deposition proceeds in one deposition source, deposition materials from other two deposition sources are blocked.

To do so, the organic layer deposition apparatus 1 according to the present embodiment includes the first and second deposition source shutters 141 and 142, so that deposition materials from other deposition sources, other than a deposition material from a target deposition source, are blocked in the tooling operation.

That is, as illustrated in FIG. 6A, in a general deposition process, the first and second deposition source shutters (not shown) are entirely or completely opened so that an organic layer is deposited on the substrate 2 by all of three deposition sources 110a, 110b, and 110c in the organic layer deposition assembly 100-1.

However, as illustrated in FIGS. 6B and 6C, when the tooling operation is performed on one of the three deposition sources 110a, 110b, and 110c in the organic layer deposition assembly 100-1, only a target deposition source to which the tooling operation is performed is opened and other two deposition sources are closed by controlling the first and second deposition source shutters 141 and 142.

As described above, by separately controlling the deposition source 110, the angle limiting plate 145, and the deposition source shutters 141 and 142, it is possible to precisely measure a thickness with respect to each deposition source in the tooling operation, so that film-forming uniformity may be improved.

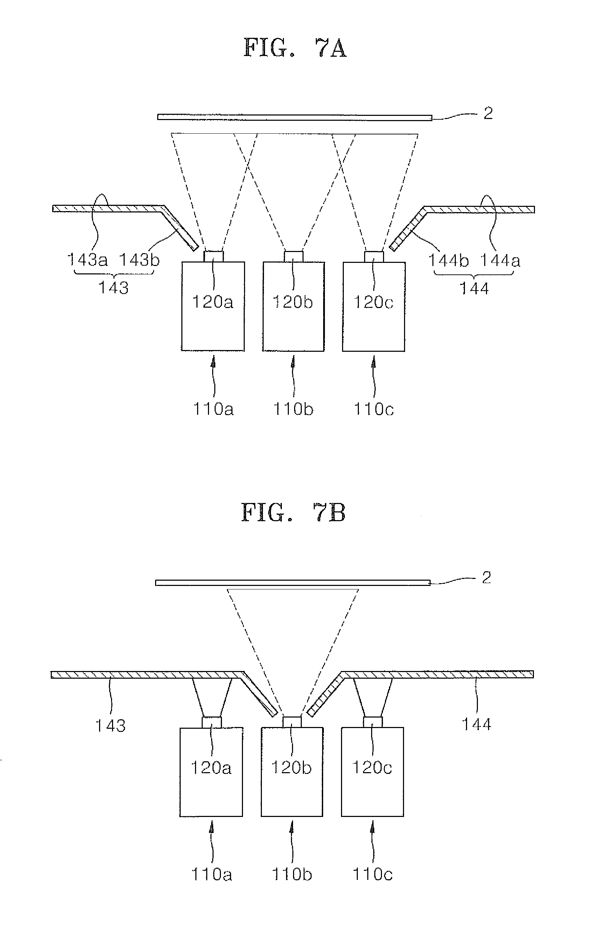

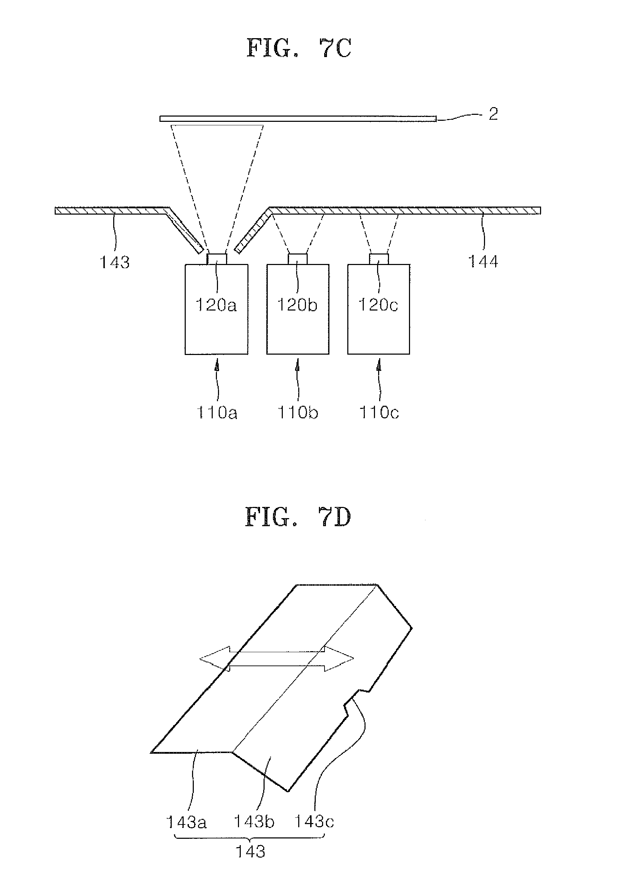

FIGS. 7A, 7B, 7C, and 7D illustrate the deposition source 110 of FIG. 3, an angle limiting plate, and a deposition source shutter, according to another embodiment of the present invention.

Referring to FIGS. 7A, 7B, 7C, and 7D, the present embodiment is **characterized in that** one deposition source shutter having functions of both angle limiting plate and deposition source shutter according to the previous embodiment of FIGS. 6A, 6B, and 6C is used. This is described in detail.

In a case of using the angle limiting plate according to the previous embodiment, nozzles are primarily located at a center of a deposition source such that a deposition material is excessively deposited at the angle limiting plate near the nozzles at the center of the deposition source according to flow of time. The excessively-deposited deposition material may prevent a flow path of a deposition material from the deposition source, thereby affecting a film-forming profile of the deposition material formed on a substrate.

In order to solve this problem, according to the present embodiment, the deposition source shutter is arranged between a deposition source (refer to the deposition source 110 of FIG. 3) and a patterning slit sheet (refer to the patterning slit sheet 130 of FIG. 3). The deposition source shutter includes a first deposition source shutter 143 and a second deposition source shutter 144 that are movable in the same direction (i.e., the direction of arrow A illustrated in FIG. 3) as a movement direction of the substrate 2. The first and second deposition source shutters 143 and 144 may block deposition materials from other deposition sources in a tooling operation. Furthermore, the first and second deposition source shutters 143 and 144 surround the deposition source 110, thereby guiding a flow path of a deposition material that is vaporized in a deposition source.

Referring to FIG. 7D that is a perspective view of the first deposition source shutter 143 according to the present embodiment, the first deposition source shutter 143 includes a flat-plate portion 143a and an inclination portion 143b, and a groove 143c is further formed (e.g., positioned or located) at an end of the inclination portion 143b. That is, because the groove 143c to function as an angle limiting plate is formed at the end of the inclination portion 143b that functions as the deposition source shutter of the previous embodiment, one deposition source shutter having functions of both angle limiting plate and deposition source shutter may be arranged.

That is, as illustrated in FIG. 7A, in a general deposition process, the first and second deposition source shutters 143 and 144 are entirely or completely opened so that an organic layer is deposited on the substrate 2 by all of three deposition sources 110a, 110b, and 110c in the organic layer deposition assembly 100-1. Here, inclination portions 143b and 144b of the first and second deposition source shutters 143 and 144 function as angle limiting plates, so that the inclination portions 143b and 144b limit flow paths of deposition materials vaporized in the deposition source 110, and increase or improve linearity of the deposition material. That is, the deposition material that is vaporized in the deposition source 110 and that moves with an angle close to 90 degrees moves toward the substrate 2 without bumping into the inclination portions 143b and 144b of the first and second deposition source shutters 143 and 144, whereas a deposition material that is vaporized in the deposition source 110 and that diagonally moves with an angle less than or equal to a predetermined angle bumps into the inclination portions 143b and 144b of the first and second deposition source shutters 143 and 144 and thus is deposited on the inclination portions 143b and 144b. By arranging the first and second deposition source shutters 143 and 144, the linearity of the deposition material may be achieved, so that the occurrence of shadows may be significantly reduced.

However, as illustrated in FIGS. 7B and 7C, when the tooling operation is performed on one of the three deposition sources 110a, 110b, and 110c in the organic layer deposition assembly 100-1, only a target deposition source to which the tooling operation is performed is opened and other two deposition sources are closed by controlling the first and second deposition source shutters 143 and 144.

As described above, by separately controlling the deposition source 110 and the deposition source shutter, it is possible to precisely measure a thickness with respect to each deposition source in the tooling operation, so that film-forming uniformity may be improved.

Although not illustrated, the organic layer deposition assembly 100-1 of the organic layer deposition apparatus 1 may further include a control sensor, an adjustment sensor, and a sensor shutter so as to control a thickness of an organic layer to be formed on the substrate 2 and thus may monitor and adjust in real-time the thickness of the organic layer. That is, layers are formed with respect to organic materials, respectively, in an initial film-forming operation by using the control sensor, the adjustment sensor, and the sensor shutter, and thicknesses of the layers are checked by using an analysis equipment such as an ellipsometer. Afterward, a TF is reflected to respective deposition sources containing respective organic materials, deposition rates thereof are checked via a monitoring sensor, and then the deposition rates via the monitoring sensor may be reference values for a monitoring operation during a film-forming operation at a later time.

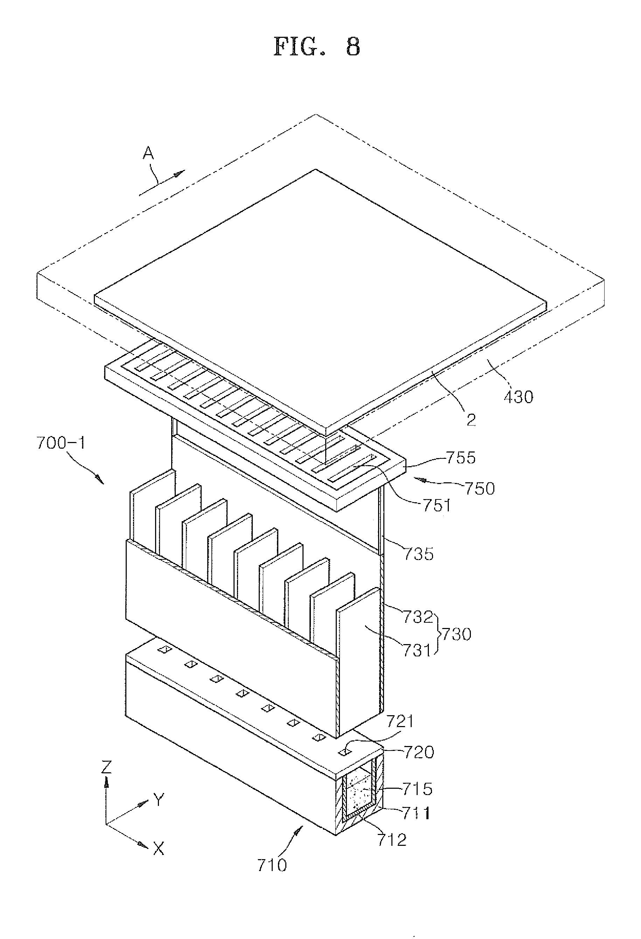

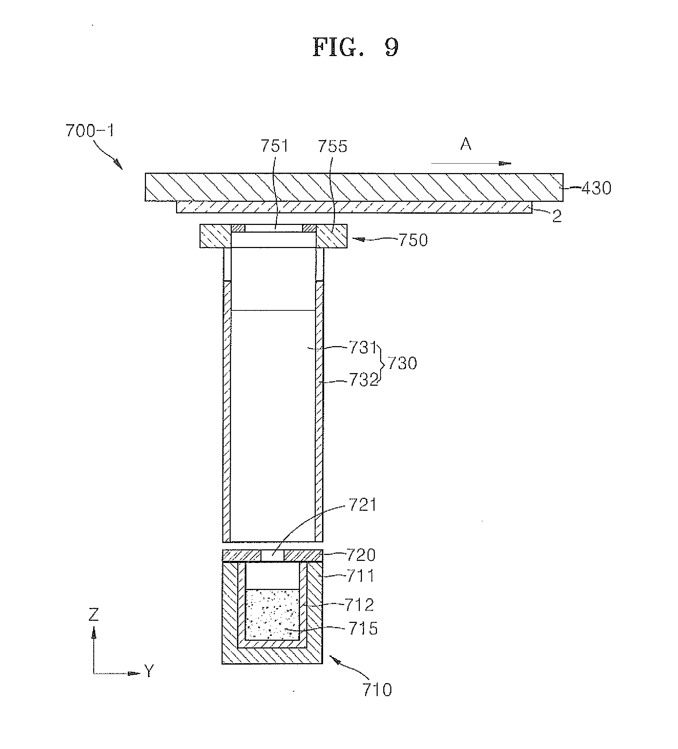

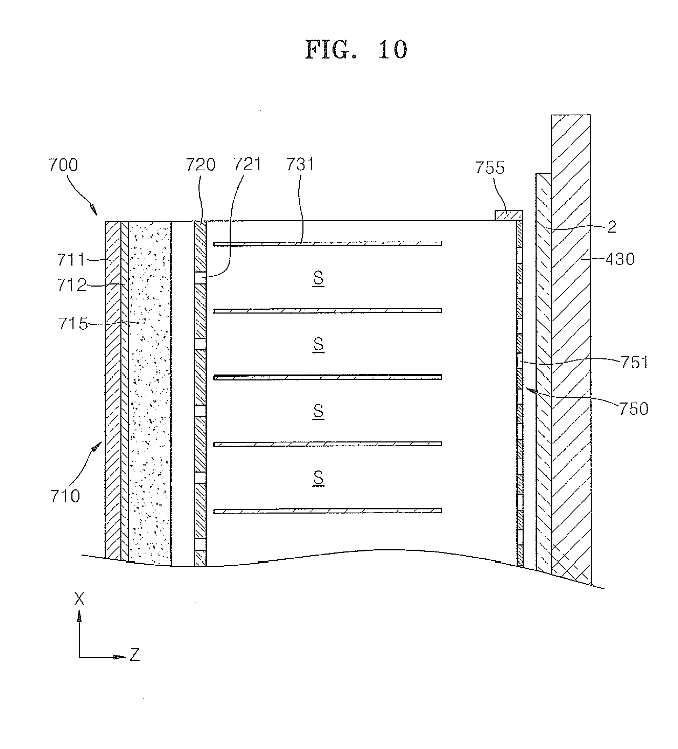

FIG. 8 is a schematic perspective view of an organic layer deposition assembly 700 according to another embodiment of the present invention. FIG. 9 is a schematic cross-sectional side view of the organic layer deposition assembly 700 of FIG. 8. FIG. 10 is a schematic cross-sectional plan view of the organic layer deposition assembly 700 of FIG. 8.

Referring to FIGS. 8 through 10, the organic layer deposition assembly 700 includes a deposition source 710, a deposition source nozzle unit 720, a shielding plate assembly (e.g., a barrier assembly or a barrier plate assembly) 730, and a patterning slit sheet 750.

The deposition source 710 includes a crucible 711 that is filled with the deposition material 715 and a heater 712 that heats the crucible 711 so as to vaporize the deposition material 715 included in the crucible 711 toward the deposition source nozzle unit 720. The deposition source nozzle unit 720 is located at a side of the deposition source 710, and a plurality of deposition source nozzles 721 are formed (or arranged) on the deposition source nozzle unit 720 along the X-axis direction.

The shielding plate assembly 730 is arranged (or located) at a side of the deposition source nozzle unit 720. The shielding plate assembly 730 includes a plurality of shielding plates (or barrier plates) 731 and a shielding plate frame 732 located on an outer side of (e.g., around or surrounding) the shielding plates 731. The shielding plates 731 are arranged in parallel to each other along the X-axis direction. Here, the shielding plates 731 are located at regular intervals. Also, each of the shielding plates 731 extends along an Y-Z plane and has a rectangular shape. The shielding plates 731 that are arranged in the aforementioned manner define (e.g., partition or divide) a space between the deposition source nozzle unit 720 and the patterning slit sheet 750 into a plurality of deposition spaces S, so that a deposition material that is exhausted (e.g., ejected or discharged) from one deposition source nozzle 721 is not mixed with deposition materials that are exhausted (e.g., ejected or discharged) from other deposition source nozzles 721, but passes through the patterning slit 751 and then is deposited onto the substrate 2 (attached to the transfer unit 430). That is, each of the shielding plates 731 functions to guide a movement path of the deposition material, so that the deposition material exhausted from each of the deposition source nozzles 721 goes straight in a Z-axis direction without (or substantially without) spreading.

As described above, a linearity of the deposition material may be improved or achieved by arrangement of the shielding plates 731, so that a size of shadows formed on the substrate 2 may be reduced (e.g., significantly reduced), and thus the organic layer deposition assembly 700 and the substrate 2 may be spaced apart from each other by a certain distance (e.g., a gap).

The patterning slit sheet 750 is further located (or positioned) between the deposition source 710 and the substrate 2. The patterning slit sheet 750 further includes a frame 755 having a shape similar to a window frame. Also, the patterning slit sheet 750 includes a plurality of patterning slits 751 arranged along an X-axis direction. The deposition material 715 that is vaporized in the deposition source 710 passes through the deposition source nozzle unit 720 and the patterning slit sheet 750 and then moves toward the substrate 2 that is a deposition target.

FIG. 11 is a schematic perspective view of an organic layer deposition assembly 800 according to another embodiment of the present invention.

Referring to FIG. 11, the organic layer deposition assembly 800 includes a deposition source 810, a deposition source nozzle unit 820, a first shielding plate assembly (e.g., a first barrier plate assembly) 830, a second shielding plate assembly (e.g., a second barrier plate assembly) 840, and a patterning slit sheet 850. Here, configurations of the deposition source 810, the first shielding plate assembly 830, and the patterning slit sheet 850 are the same (or substantially the same) as those described above with reference to FIG. 8, thus, detailed descriptions thereof are omitted. The patterning slit sheet 850 includes a plurality of patterning slits 851 arranged along the X-direction. An intermediate region is between each pair of adjacent patterning slits 851. The present embodiment is different from the previous embodiments in that the second shielding plate assembly 840 is arranged at a side of the first shielding plate assembly 830.

In more detail, the second shielding plate assembly 840 includes a plurality of second shielding plates (e.g., second barrier plates) 841 and a second shielding plate frame 842 located on an outer side of (e.g., around or surrounding) the second shielding plates 841. The second shielding plates 841 are arranged in parallel with each other along the X-axis direction. Also, the second shielding plates 841 are arranged at regular intervals. Also, each of the second shielding plates 841 extends along an Y-Z plane, i.e., may be perpendicular to the X-axis direction.

A plurality of first shielding plates 831 and the second shielding plates 841, which are arranged in the aforementioned manner, define (e.g., divide or partition) a space between the deposition source nozzle unit 820 and the patterning slit sheet 850. That is, the present embodiment is **characterized in that** deposition spaces are defined respectively with respect to a plurality of deposition source nozzles 821 that spray deposition material, due to the first shielding plates 831 and the second shielding plates 841.

Here, the first shielding plates 831 and the second shielding plates 841 are arranged to correspond to each other. In other words, the first shielding plates 831 align with the second shielding plates 841, respectively, and thus are in parallel with each other. That is, the first shielding plate 831 and the second shielding plate 841 that correspond to each other are positioned on the same plane (or substantially the same plane). Referring to FIG. 10, a width or thickness of each first shielding plate 831 is equal to (or substantially the same as) an X-axis direction width of each second shielding plate 841 but aspects ofi the present invention are not limited thereto. That is, the second shielding plates 841 that are accurately (or precisely) aligned with the adjacent patterning slits 851 may be relatively thin whereas the first shielding plates 831 that are not necessarily accurately (or precisely) aligned with the adjacent patterning slits 851 may be relatively thick for ease of manufacturing.

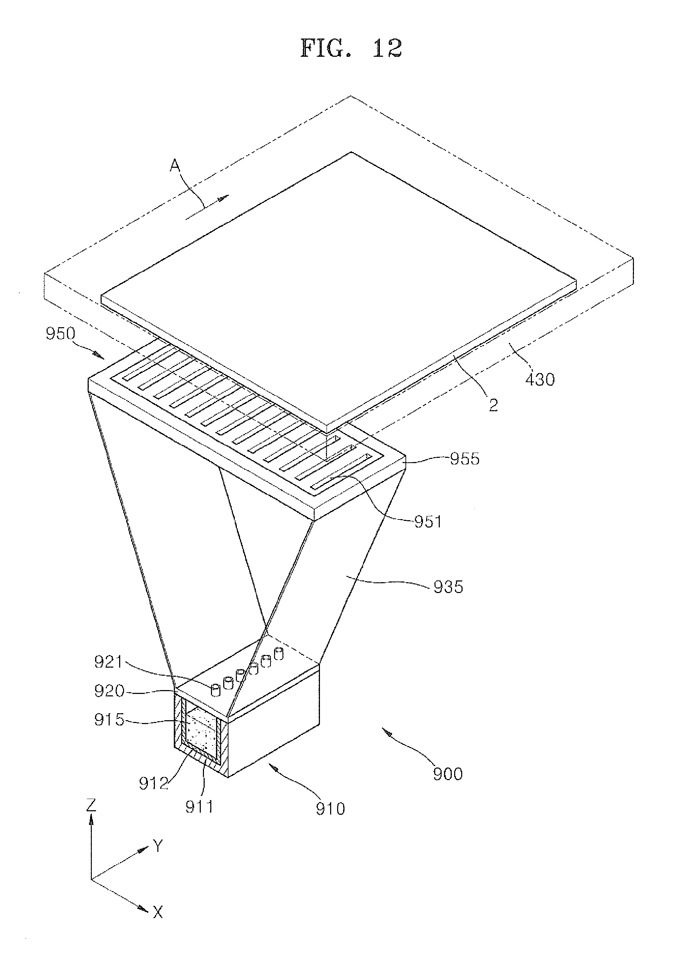

FIG. 12 is a schematic perspective view of an organic layer deposition assembly 900 according to another embodiment of the present invention.

Referring to FIG. 12, the organic layer deposition assembly 900 includes a deposition source 910, a deposition source nozzle unit 920, and a patterning slit sheet 950.

The deposition source 910 includes a crucible 911 that is filled with a deposition material 915 and a heater 912 that heats the crucible 911 so as to vaporize a deposition material 915 included in the crucible 911 toward the deposition source nozzle unit 920. The deposition source nozzle unit 920 is located at a side of the deposition source 910, and a plurality of deposition source nozzles 921 are formed (or arranged) on the deposition source nozzle unit 920 along a Y-axis direction. Also, the patterning slit sheet 950 and a frame 955 are further positioned or arranged between the deposition source 910 and the substrate 2, and a plurality of patterning slits 951 are formed or arranged at the patterning slit sheet 950 along an X-axis direction. A spacer (or an intermediate region) is located between each pair of adjacent patterning slits 951. The deposition source 910 and the deposition source nozzle unit 920, and the patterning slit sheet 950 are combined by using connection members 935.

The present embodiment is different from the previous embodiments in an array of the deposition source nozzles 921 formed or arranged at the deposition source nozzle unit 920. Hereinafter, the difference is described as below.

The deposition source nozzle unit 920 is located at a side of the deposition source 910 so as face the substrate 2. The deposition source nozzles 921 are formed or arranged on the deposition source nozzle unit 920 along the Y-axis direction, i.e., along a scanning direction of the substrate 2. Here, the deposition source nozzles 921 may be located or arranged at regular intervals. The deposition material 915 that has been vaporized in the deposition source 910 passes through the deposition source nozzle unit 920 and then moves toward the substrate 2 that is a deposition target. To that end, in the organic layer deposition assembly 900, the deposition source nozzles 921 are formed or arranged along the scanning direction of the substrate 2. In this regard, if the deposition source nozzles 921 were formed along the X-axis direction, distances between the respective deposition source nozzles 921 and the respective patterning slits 951 would differ from each other, so that shadows would occur due to a deposition material that has been discharged from the deposition source nozzle 921 that is distant from the corresponding patterning slit 951. Thus, in the present embodiment, only one deposition source nozzle 921 is formed or arranged along the X-axis direction, and thus the occurrence of shadows may be reduced (e.g., significantly reduced). Also, since the deposition source nozzles 921 are formed along the scanning direction of the substrate 2, a difference in flux occurring between the deposition source nozzles 121 may be compensated for and deposition uniformity may be maintained constant (or substantially constant).

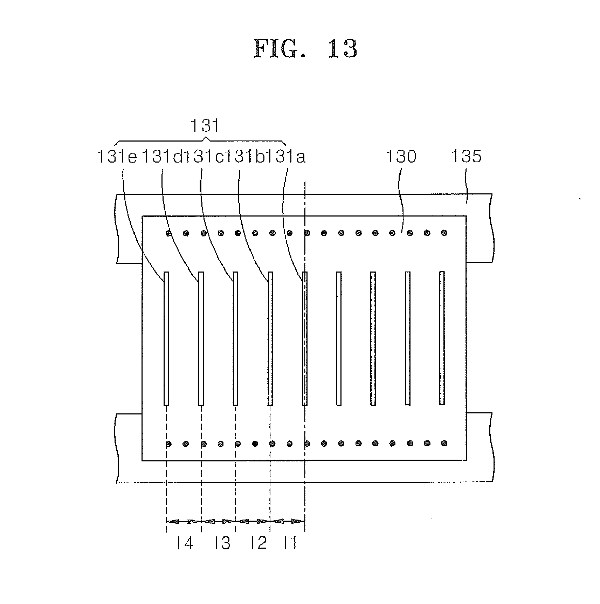

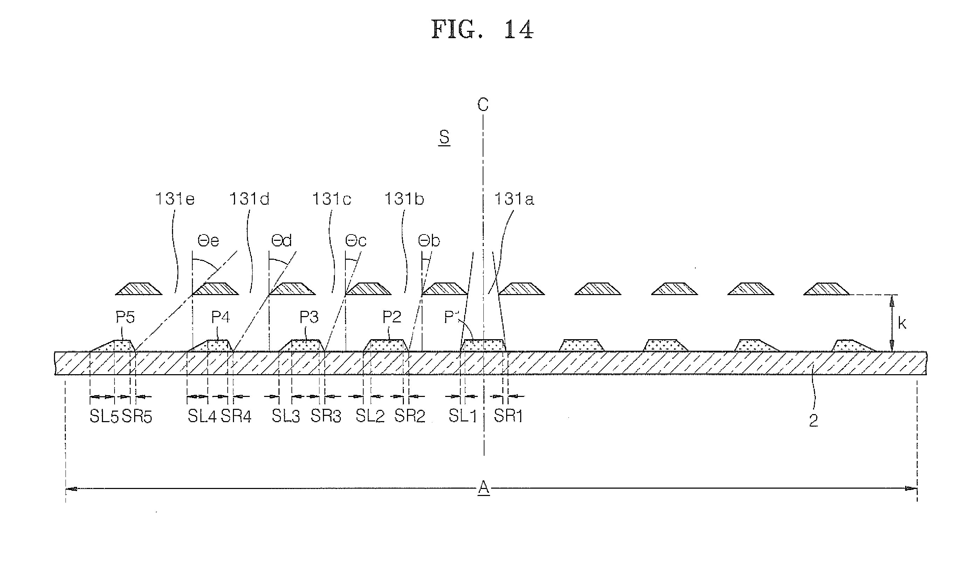

FIG. 13 is a diagram illustrating a structure in which the patterning slits 131 are arranged at equal intervals in the patterning slit sheet 130 of the organic layer deposition apparatus 1, according to an embodiment of the present invention. FIG. 14 is a diagram illustrating organic layers formed on the substrate 2 by using the patterning slit sheet 130 of FIG. 13, according to an embodiment of the present invention.

FIGS. 13 and 14 schematically illustrate the patterning slit sheet 130 in which the patterning slits 131 are arranged at equal intervals. That is, in FIG. 13, the patterning slits 131 satisfy the following condition: I₁ = I₂ = I₃ = I₄.

In this embodiment, an incident angle of a deposition material discharged along a center line C of a deposition space S is substantially perpendicular to the substrate 2. Thus, an organic layer P₁ formed using the deposition material that has passed through a patterning slit 131a has a minimum (or reduced) size of a shadow, and a right-side shadow SR₁ and a left-side shadow SL₁ are formed symmetrical to (or symmetrically with) each other.

However, a critical incident angle θ of the deposition material that passes through patterning slits located farther from the center line C of the deposition space S gradually increases, and thus, in one embodiment, the critical incident angle θ of the deposition material that passes through the outermost patterning slit 131e is approximately 55°. Accordingly, the deposition material is incident at an inclination with respect to the patterning slit 131e, and an organic layer P₅ formed using the deposition material that has passed through the patterning slit 131e has the largest shadow. For example, a left-side shadow SL₅ is larger than a right-side shadow SR₅.

That is, as the critical incident angle θ of the deposition material increases, the size of the shadow also increases. For example, the size of the shadow at a position farther from the center line C of the deposition space S increases. In addition, the critical incident angle θ of the deposition material increases as a distance between the center line C of the deposition space S and the respective patterning slits increases. Thus, organic layers formed using the deposition material that passes through the patterning slits located farther from the center line C of the deposition space S have a relatively larger shadow size. For example, of the shadows on both sides of the respective organic layers, the size of the shadow at a position farther from the center line C of the deposition space S is larger than that of the other.

That is, referring to FIG. 14, the organic layers formed on the left side of the center line C of the deposition space S have a structure in which a left hypotenuse (a slanted side on the left between top and bottom sides) is larger than a right hypotenuse (a slanted side on the right between the top and bottom sides), and the organic layers formed on the right side of the center line C of the deposition space S have a structure in which a right hypotenuse (e.g., a right slanted side) is larger than a left hypotenuse (e.g., a left slanted side).

Also, in the organic layers formed on the left side of the center line C of the deposition space S, the length of the left hypotenuse (e.g., the left slanted side) increases towards the left. In the organic layers formed on the right side of the center line C of the deposition space S, the length of the right hypotenuse (e.g., the right slanted side) increases towards the right. Consequently, the organic layers formed in the deposition space S may be formed symmetrical to each other about the center line C of the deposition space S.

This structure will now be described in more detail.

The deposition material that passes through a patterning slit 131b passes through the patterning slit 131b at a critical incident angle of θ_{b}, and an organic layer P₂ formed using the deposition material that has passed through the patterning slit 131b has a left-side shadow having a size of SL₂. Similarly, the deposition material that passes through a patterning slit 131c passes through the patterning slit 131c at a critical incident angle of θ_{c}, and an organic layer P₃ formed using the deposition material that has passed through the patterning slit 131c has a left-side shadow having a size of SL₃. Similarly, the deposition material that passes through a patterning slit 131d passes through the patterning slit 131d at a critical incident angle of θ_{d}, and an organic layer P₄ formed using the deposition material that has passed through the patterning slit 131d has a left-side shadow having a size of SL₄. Similarly, the deposition material that passes through the patterning slit 131e passes through the patterning slit 131e at a critical incident angle of θₑ, and an organic layer P₅ formed using the deposition material that has passed through the patterning slit 131e has a left-side shadow having a size of SL₅.

In this regard, the critical incident angles satisfy the following condition: θ_{b} < θ_{c} < θ_{d} < θₑ, and thus, the sizes of the shadows of the organic layers also satisfy the following condition: SL₁ < SL₂ < SL₃ < SL₄ < SL₅.

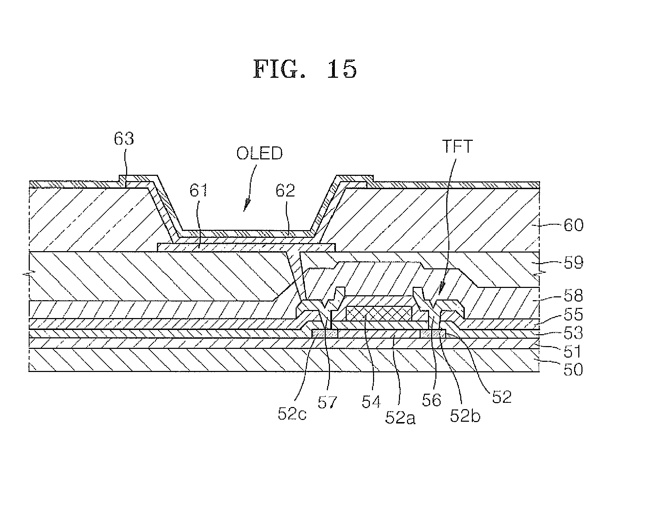

FIG. 15 is a schematic cross-sectional view of an active matrix-type organic light-emitting display device manufactured using the organic layer deposition apparatus 1, according to an embodiment of the present invention.

Referring to FIG. 15, the active matrix organic light-emitting display device 10 according to the current embodiment is formed on the substrate 50. The substrate 2 may be formed of a transparent material, for example, glass, plastic, or metal. An insulating layer 51, such as a buffer layer, is formed on an entire surface of the substrate 2. The insulating layer 15 may be omitted in other embodiments.

A thin film transistor (TFT) and an organic light-emitting diode (OLED) are formed on the insulating layer 51, as illustrated in FIG. 15.

A semiconductor active layer 52 is formed on an upper surface of the insulating layer 51 in a set or predetermined pattern. A gate insulating layer 53 is formed to cover the semiconductor active layer 52. The semiconductor active layer 52 may include a p-type or n-type semiconductor material.

A gate electrode 54 of the TFT is formed in a region of the gate insulating layer 53 corresponding to the semiconductor active layer 52. An interlayer insulating layer 55 is formed to cover the gate electrode 54. The interlayer insulating layer 55 and the gate insulating layer 53 are etched by, for example, dry etching, to form contact holes respectively exposing parts of the semiconductor active layer 52.

Source and drain electrodes 56 and 57 are formed on the interlayer insulating layer 55 to contact the semiconductor active layer 52 through the respective contact holes. A passivation layer 58 is formed to cover the source and drain electrodes 56 and 57, and is etched to expose a part of one of the source and drain electrodes 56 and 57. An insulating layer 59 may be further formed on the passivation layer 58 so as to planarize the passivation layer 58.

In addition, the OLED displays image information (e.g., set or predetermined image information) by emitting red, green, or blue light according to current. The OLED includes a first electrode 61 located on the insulating layer 59. The first electrode 61 is electrically connected to the exposed one of the source and drain electrodes 56 and 57 of the TFT 40.

A pixel-defining layer 60 is formed to cover the first electrode 61. An opening is formed in the pixel-defining layer 60, and an organic layer 62 including an emission layer (EML) is formed in a region defined by the opening. A second electrode 63 is formed on the organic layer 62.

The pixel-defining layer 60, which defines individual pixels, may be formed of an organic material. The pixel-defining layer 60 also planarizes the surface of a region of the substrate 50 in which the first electrode 61 is formed, and in particular, the surface of the insulating layer 59.

The first electrode 61 and the second electrode 63 are electrically insulated from each other, and respectively apply voltages of opposite polarities to the organic layer 62 to induce light emission.

The organic layer 62, including an EML, may be formed of a low-molecular weight organic material or a high-molecular weight organic material. When a low-molecular weight organic material is used, the organic layer 62 may have a single or multi-layer structure including a hole injection layer (HIL), a hole transport layer (HTL), the EML, an electron transport layer (ETL), and/or an electron injection layer (EIL). Non-limiting examples of available organic materials may include copper phthalocyanine (CuPc), N,N'-di(naphthalene-1-yl)-N,N'-diphenyl-benzidine (NPB), and tris-8-hydroxyquinoline aluminum (Alq₃).

The organic layer 62 including an EML may be formed using any suitable embodiment of the organic layer deposition apparatus 1 illustrated in FIGS. 1 through 14 or any other suitable organic layer deposition apparatus using principles of the present invention. For example, an organic layer deposition apparatus including a deposition source that discharges a deposition material, a deposition source nozzle unit that is located at a side of the deposition source and includes a plurality of deposition source nozzles formed therein, and a patterning slit sheet that faces the deposition source nozzle unit and includes a plurality of patterning slits formed therein is located spaced apart by a set or predetermined distance from a substrate on which the deposition material is to be deposited. In addition, the deposition material discharged from the organic layer deposition apparatus 1 (e.g., refer to FIG. 1) is deposited on the substrate 2 (e.g., refer to FIG. 1) while the organic layer deposition apparatus 1 and the substrate 2 are moved relative to each other.

After the organic layer 62 is formed, the second electrode 63 may be formed by the same deposition method as used to form the organic layer 62.

The first electrode 61 may function as an anode, and the second electrode 63 may function as a cathode. Alternatively, the first electrode 61 may function as a cathode, and the second electrode 63 may function as an anode. The first electrode 61 may be patterned to correspond to individual pixel regions, and the second electrode 63 may be formed to cover all the pixels.

The first electrode 61 may be formed as a transparent electrode or a reflective electrode. Such a transparent electrode may be formed of indium tin oxide (ITO), indium zinc oxide (IZO), zinc oxide (ZnO), or indium oxide (In₂O₃). Such a reflective electrode may be formed by forming a reflective layer from silver (Ag), magnesium (Mg), aluminum (Al), platinum (Pt), palladium (Pd), gold (Au), nickel (Ni), neodymium (Nd), iridium (Ir), chromium (Cr) or a compound thereof and forming a layer of ITO, IZO, ZnO, or In₂O₃ on the reflective layer. The first electrode 61 may be formed by forming a layer by, for example, sputtering, and then patterning the layer by, for example, photolithography.

The second electrode 63 may also be formed as a transparent electrode or a reflective electrode. When the second electrode 63 is formed as a transparent electrode, the second electrode 63 may be used as a cathode. To this end, such a transparent electrode may be formed by depositing a metal having a low work function, such as lithium (Li), calcium (Ca), lithium fluoride/calcium (LiF/Ca), lithium fluoride/aluminum (LiF/Al), aluminum (Al), silver (Ag), magnesium (Mg), or a compound thereof on a surface of the organic layer 62 and forming an auxiliary electrode layer or a bus electrode line thereon from ITO, IZO, ZnO, In₂O₃, or the like. When the second electrode 63 is formed as a reflective electrode, the reflective layer may be formed by depositing Li, Ca, LiF/Ca, LiF/Al, Al, Ag, Mg, or a compound thereof on the entire surface of the organic layer 62. The second electrode 63 may be formed using the same deposition method as used to form the organic layer 62 described above.

The organic layer deposition apparatuses according to the embodiments of the present invention described above may be applied to form an organic layer or an inorganic layer of an organic TFT, and to form layers from various suitable materials.

According to one or more embodiments of the present invention, it is possible to embody the organic layer deposition apparatus that is suitable for use in the mass production of a large substrate. Embodiments of the present invention enable high-definition patterning. Also provided according to embodiments of the present invention is a method of manufacturing an organic light-emitting display apparatus by using the organic layer deposition apparatus, and the organic light-emitting display apparatus manufactured using the method.

While the present invention has been particularly shown and described with reference to embodiments thereof, it will be understood by those of ordinary skill in the art that various changes in form and details may be made therein without departing from the scope of the present invention as defined by the following claims and their equivalents.

## Claims

1. An organic layer deposition apparatus comprising:
a conveyer unit comprising a transfer unit for attaching a substrate, the transfer unit being configured to move along with the substrate, a first conveyer unit for moving in a first direction the transfer unit to which the substrate is attached, and a second conveyer unit for moving in a direction opposite to the first direction the transfer unit from which the substrate is separated after deposition has been completed; and
a deposition unit comprising a chamber configured to be maintained in a vacuum state and an organic layer deposition assembly for depositing an organic layer on the substrate attached to the transfer unit,
wherein the organic layer deposition assembly comprises:
a deposition source for discharging a deposition material;
a deposition source nozzle unit at a side of the deposition source, and comprising a plurality of deposition source nozzles;
a patterning slit sheet facing the deposition source nozzle unit, and comprising a plurality of patterning slits that are arranged in a first direction; and
a deposition source shutter that is movable in the first direction, and configured to selectively block the deposition material that is vaporized in the deposition source,
wherein the transfer unit is configured to move between the first conveyer unit and the second conveyer unit, and to keep the attached substrate spaced apart from the organic layer deposition assembly while being transferred by the first conveyer unit.

2. An organic layer deposition apparatus according to claim 1, wherein the organic layer deposition assembly further comprises an angle limiting plate at a side of the deposition source to guide a flow path of the deposition material that is vaporized in the deposition source.

3. An organic layer deposition apparatus according to claim 2, wherein the angle limiting plate surrounds a portion of the deposition source.

4. An organic layer deposition apparatus according to any preceding claim, wherein the deposition source shutter comprises a first deposition source shutter and a second deposition source shutter that at least partially have a flat plate shape, and the deposition source is adapted to be opened or closed due to movement of the first deposition source shutter and the second deposition source shutter.

5. An organic layer deposition apparatus according to one of claims 1 to 4, wherein the deposition source shutter comprises a first deposition source shutter and a second deposition source shutter, and
wherein each of the first deposition source shutter and the second deposition source shutter comprises a flat-plate portion and an inclination portion that is bent from the flat-plate portion.

6. An organic layer deposition apparatus according to claim 5, wherein a groove is at an end of the inclination portion and corresponds to one of the plurality of deposition source nozzles.

7. An organic layer deposition apparatus according to claim 5 or 6, wherein the inclination portion is configured to guide a flow path of the deposition material that is vaporized in the deposition source.

8. An organic layer deposition apparatus according to any preceding claim, further comprising a control sensor at a side of the deposition source to measure a deposition rate of the deposition material that is vaporized in the deposition source.

9. An organic layer deposition apparatus according to claim 8, wherein the control sensor is configured to measure the deposition rate of the deposition material while the transfer unit moves along with the substrate, such that a vaporization amount of the deposition material that is vaporized in the deposition source can be controlled by using the deposition rate.

10. An organic layer deposition apparatus according to any preceding claim, wherein the deposition rate of the deposition source which is measured by the control sensor is controlled to deposit the deposition material on the substrate by a target thickness.

11. A method of manufacturing an organic light-emitting display apparatus, the method comprising:
moving a transfer unit to which the substrate is attached into a chamber, using a first conveyer unit passing through the chamber;
while the substrate and a plurality of organic layer deposition assemblies in the chamber are spaced apart from each other ,and the substrate relatively moves with respect to the organic layer deposition assemblies, depositing deposition materials discharged from the organic layer deposition assemblies on the substrate to form organic layers; and
moving the transfer unit, from which the substrate is separated, using a second conveyer unit passing through the chamber,
wherein each of the organic layer deposition assemblies comprises:
a deposition source for discharging the deposition material;
a deposition source nozzle unit at a side of the deposition source, and comprising a plurality of deposition source nozzles;
a patterning slit sheet facing the deposition source nozzle unit, and comprising a plurality of patterning slits; and
a deposition source shutter that is movable in a first direction, and configured to selectively block the deposition material that is vaporized in the deposition source, and
wherein the depositing the deposition materials comprises measuring a deposition rate of each of a plurality of the deposition sources by sequentially opening or closing the plurality of the deposition sources using the deposition source shutter.

12. An organic light-emitting display device comprising:
a substrate;
a plurality of thin film transistors on the substrate, each of the thin film transistors comprising a semiconductor active layer, a gate electrode insulated from the semiconductor active layer, and source and drain electrodes each contacting the semiconductor active layer;
a plurality of pixel electrodes respectively on the thin film transistors;
a plurality of organic layers respectively on the plurality of pixel electrodes; and
a counter electrode on the plurality of organic layers,
wherein a length of a slanted side between top and bottom sides of at least one of the plurality of organic layers on the substrate farther from a center of a deposition region is larger than lengths of slanted sides respectively between top and bottom sides of those other organic layers closer to the center of the deposition region, and
wherein the at least one of the plurality of organic layers on the substrate is a linearly-patterned organic layer formed using the organic layer deposition apparatus of claim 1

13. An organic light-emitting display device according to claim 12, wherein the plurality of organic layers have a non-uniform thickness.

14. An organic light-emitting display device according to claim 12 or 13, wherein in each of the organic layers that is farther from the center of the deposition region, the slanted side that is farther from the center of the deposition region is larger than the other slanted side.

15. An organic light-emitting display device according to one of claims 12 to 14, wherein the farther one of the plurality of organic layers in the deposition region is from the center of the deposition region, the narrower an overlapped region of two sides of the one of the plurality of organic layers is formed.

16. An organic light-emitting display device according to one of claims 12 to 15, wherein the slanted sides of the organic layer at the center of the deposition region have substantially the same length as each other.

17. An organic light-emitting display device according to one of claims 12 to 16, wherein the plurality of organic layers in the deposition region are symmetrically arranged about the center of the deposition region.

18. An organic light-emitting display device according to one of claims 12 to 17, wherein the substrate has a size of 40 inches or more.
